Europäisches Patentamt

European Patent Office

Office européen des brevets

(19)

(11) Veröffentlichungsnummer: **0 030 273**
**A2**

# (12) EUROPÄISCHE PATENTANMELDUNG

(21) Anmeldenummer: 80106773.7

(22) Anmeldetag: 04.11.80

(51) Int. Cl.³: **H 01 L 29/06, H 01 L 29/72**
// H01L21/31

(30) Priorität: 07.11.79 DE 2944937

(43) Veröffentlichungstag der Anmeldung: **17.06.81**
**Patentblatt 81/24**

(84) Benannte Vertragsstaaten: **FR GB IT**

(71) Anmelder: **SIEMENS AKTIENGESELLSCHAFT Berlin und München, Postfach 22 02 61, D-8000 München 22 (DE)**

(72) Erfinder: **Arlt, Manfred, Pentenriederstrasse 46, D-8033 Krailling (DE)**
Erfinder: **Dathe, Joachim, Schleissheimer Strasse 276, D-8000 München 40 (DE)**
Erfinder: **Mitlehner, Heinz, Dr., Hohenzollernstrasse 104, D-8000 München 40 (DE)**

(54) **Halbleiterbauelement mit einem Schutzring.**

(57) Die Erfindung betrifft ein Halbleiterbauelement mit mindestens einem pn-Übergang zwischen einem Halbleiterkörper (1) und einer entgegengesetzt zum Halbleiterkörper (1) dotierten Zone (6). Auf der Isolierschicht (4), die die Oberfläche des Halbleiterkörpers (1) und der Zone (6) überdeckt, ist eine halbisolierende Schicht (10) vorgesehen, die auf ihren Seiten auf verschiedenen Potentialen gehalten wird. Die Erfindung eignet sich besonders für hochsperrende Transistoren und Dioden.

EP 0 030 273 A2

0030273

SIEMENS AKTIENGESELLSCHAFT    Unser Zeichen
Berlin und München    VPA
    **79 P 1 1 8 5** EUR

<u>Halbleiterbauelement</u>

Die Erfindung betrifft ein Halbleiterbauelement, mit mindestens einem pn-Übergang, der in einem Halbleiterkörper des einen Leitungstyps ausgeführt ist, auf dem eine Isolierschicht aufgetragen ist, die den an die Oberfläche des Halbleiterkörpers tretenden pn-Übergang überdeckt, mit einem im Abstand vom pn-Übergang vorgesehenen Schutzring und mit einem die Isolierschicht überdeckenden Film.

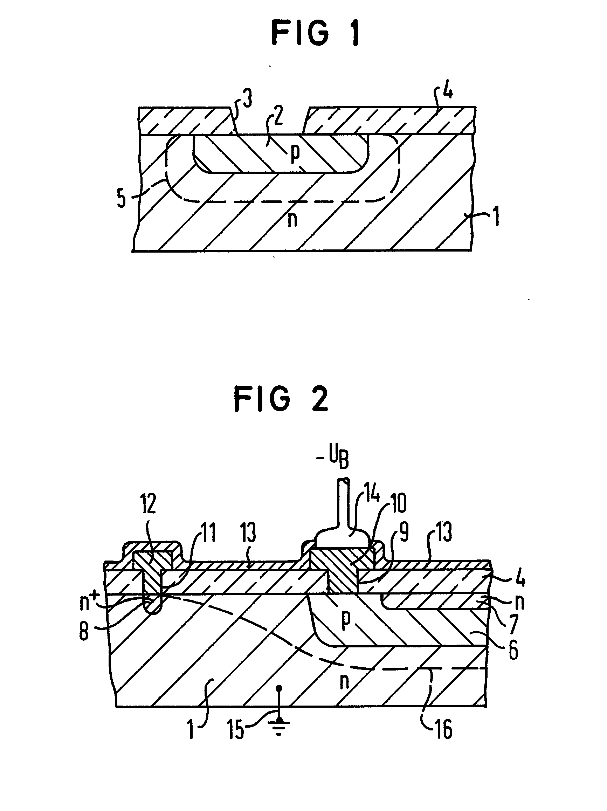

Bei Planarstrukturen, wie zum Beispiel Planartransistoren, wird die Durchbruchsspannung durch den kleinsten Krümmungsradius des Verlaufes der Raumladungszone begrenzt. Fig. 1 zeigt eine derartige Planarstruktur:

In einem n-leitenden Halbleiterkörper 1 ist eine p-leitende Zone 2 angeordnet, die über ein Fenster 3 in einer aus Siliciumdioxid bestehenden Isolierschicht 4 kontaktiert wird. Wenn nun an den pn-Übergang zwischen dem Halbleiterkörper 1 und der Zone 2 eine Spannung gelegt

Kot 1 Dx / 05.11.1979

0030273

wird, entsteht eine Raumladungszone, deren Verlauf durch eine Strichlinie 5 angedeutet ist. Der Krümmungsradius $r_1$ des Verlaufes der Raumladungszone 5 hängt von den Grenzflächenladungen ab. Dagegen wird der Krümmungsradius $r_2$ im wesentlichen durch die Tiefe der Eindiffusion oder Implantation der Zone 2 in den Halbleiterkörper 1 festgelegt.

Mit immer flacher werdenden Strukturen wird dann der Krümmungsradius $r_2$ immer kleiner und damit die Durchbruchsspannung immer niedriger. Die Größe des Krümmungsradius $r_1$ kann dagegen durch Oberflächenpräparation und Technologiebedingungen bestimmt werden.

Sollen bei gleichbleibender Implantations- oder Diffusionstiefe möglichst hohe Spannungen erzielt werden, müssen die Krümmungsradien $r_1$ und $r_2$ möglichst groß ausgeführt werden.

Zur Stabilisierung von Halbleiterbauelementen wurden bereits verschiedene Möglichkeiten erwogen:

Bereits vor längerer Zeit wurde ein Transistor beschrieben, dessen Basiselektrode sich auf einer mit Phosphor dotierten Isolierschicht über den Basis-Kollektor-pn-Übergang hinaus erstreckt ("extended base-Elektrode"), wobei in der Kollektorzone ein mit einer Feldelektrode (Äquipotentialfläche) versehener Schutzring vorgesehen ist, der die Basiszone im Abstand umgibt (vergleiche DE-OS 1 920 397). Weiterhin wurde ein Halbleiterbauelement entwickelt (vergleiche DE-OS 26 32 647), das an seinem Rand mit einer passivierenden Schutzschicht aus aufgedampftem Silicium versehen ist. Schließlich gibt es noch ein Verfahren zum Stabilisieren der Oberfläche von Halbleiterkörpern mit pn-Übergängen durch Vakuumbedampfen, bei dem auf die Oberfläche von Halbleiterkörpern eine Schicht aus amorphem Germanium aufgedampft
wird (vergleiche DE-AS 1 184 178).

Durch eine "extended base-Elektrode" läßt sich der Krümmungsradius $r_2$ vergrößern; dabei bedarf es allerdings
einer sehr guten Passivierung für die Isolierschicht, um
die Stabilität zu gewährleisten. Weiterhin wird der
Krümmungsradius $r_1$ durch die oberhalb der Isolierschicht
verlaufende Basiselektrode und den Schutzring mit Feldelektrode infolge der Kompensation der Oxidladungen verringert.

Es ist Aufgabe der Erfindung, ein Halbleiterbauelement
mit geringer Diffusions- beziehungsweise Implantationstiefe und hoher Durchbruchsspannung anzugeben.

Diese Aufgabe wird bei einem Halbleiterbauelement der
eingangs genannten Art erfindungsgemäß dadurch gelöst,
daß der Film halbisolierend ist und mindestens zwei Bereiche mit einem genau festlegbaren Potential hat.

In einer Weiterbildung der Erfindung ist vorgesehen, daß
der Film aus amorphem Silicium besteht.

Weiterhin ist vorteilhaft, daß der Film vorzugsweise
500 Å dick ist.

Schließlich besteht eine Weiterbildung der Erfindung
noch darin, daß die Isolierschicht aus Siliciumdioxid
beziehungsweise Siliciumdioxid und Siliciumnitrid besteht.

Bei der Erfindung wird also ein halbisolierender Film,
der gegebenenfalls auch aus mehreren Schichten bestehen kann, auf die Isolierschicht aufgebracht, die auf dem Halbleiterkörper vorgesehen ist. Für den halbisolierenden Film kann beispielsweise amorphes Silicium verwendet werden. Weiterhin kann die Isolierschicht aus Siliciumdioxid beziehungsweise Siliciumdioxid und Siliciumnitrid bestehen.

Der Film hat in vorteilhafter Weise auf beiden Seiten ein definiertes Potential, nämlich beispielsweise einerseits das Potential des Basis- oder Emitterkontaktes und andererseits das Potential der Äquipotentialfläche, das heißt der Kollektorzone.

Der gegebenenfalls durch den Film fließende parasitäre Sperrstrom kann durch die Prozeßtechnologie für den amorphen Film und die Oberflächentopologie (Spaltbreite beziehungsweise Spaltlänge) den Anforderungen an die Bauelemente angepaßt werden. Die Barrierenhöhe der Kontaktierung sollte nach Möglichkeit kleiner als 1 % der angelegten Spannung sein.

Das erfindungsgemäße Halbleiterbauelement hat insbesondere folgende Vorteile:

a) Es ist auf einfache Weise ohne wesentliche zusätzliche Verfahrensschritte herstellbar,

b) die Passivierung ist gegenüber Ladungen oberhalb der Isolierschicht wirkungsvoll,

c) durch die Passivierung wird keine zusätzliche Kapazität bewirkt,

d) ein Wanderungseffekt der elektrischen Bauelementedaten auf Grund heißer Elektronen wird verhindert,

e) der Krümmungsradius $r_2$ wird abhängig von der zur Verfügung stehenden Halbleiterkörper-Oberfläche stark vergrößert; der Krümmungsradius $r_2$ kann in gewünschter Weise gesteuert werden,

f) eine Kontaktierung nach ganzflächiger Beschichtung des Halbleiterkörpers mit dem Film ist bis zu Filmdicken von 500 Å unproblematisch, da dann ohne weiteres ein Durchkontaktieren durch den Film möglich ist; bei größeren Filmdicken können die Kontakte gesintert werden,

g) es liegt ein Korrosionsschutz der Anschlußelektroden vor, da laterale Diffusionsvorgänge, wie beispielsweise die sogenannte "Purpurpest", behindert werden.

An Hand der Zeichnung wird die Erfindung nachfolgend näher erläutert. Es zeigen:

Fig. 1 einen Schnitt durch ein bestehendes Halbleiterbauelement (vergleiche oben),
Fig. 2 einen Schnitt durch ein erfindungsgemäßes Halbleiterbauelement.

In Fig. 2 ist ein n-leitendes Halbleitersubstrat 1 vorgesehen, das als Kollektor eines Transistors dient. In das Halbleitersubstrat 1 ist durch Diffusion oder Implantation eine p-leitende Zone 6 eingebracht, die als Basiszone dient. In der Basiszone 6 ist eine durch Diffusion oder Implantation erzeugte $n^+$-leitende Zone 7 vorgesehen, die als Emitterzone wirkt. Der pn-Übergang zwischen der Zone 6 und dem Halbleiterkörper 1 ist im Abstand von einem $n^+$-leitenden Schutzring 8 umgeben. Auf der Oberfläche des Halbleiterkörpers 1 beziehungsweise der Zonen 6 und 7 ist eine Isolierschicht 4 aus Siliciumdioxid und Siliciumnitrid vorgesehen, die Fenster 9 und 11 aufweist, durch die Kontakte 10 und 12 in Verbindung mit der Zone 6 beziehungsweise mit dem Schutzring 8 sind.

Erfindungsgemäß befindet sich auf der gesamten Anordnung ein halbisolierender Film 13 aus amorphem Silicium. Der Film 13 weist eine Schichtdicke unter 500 Å auf, so daß die Kontakte 10 und 12 leicht durch den Film 13 hindurch kontaktiert werden können, wie dies durch einen Anschluß 14 für die Basisspannung $-U_B$ angedeutet ist. Der Film 13 wird auf zwei verschiedenen Potentialen gehalten, nämlich einerseits auf dem Potential des über einen Anschluß 15 geerdeten Halbleiterkörpers 1 mittels des Schutzringes 8 und des Kontaktes 12 und andererseits auf dem Potential der Zone 6 mittels des Kontaktes 10.

Durch die dadurch im halbisolierenden Film 13 entstehende Potentialdifferenz erhält die Raumladungszone den durch eine Kurve 16 angedeuteten Verlauf, der sich durch sehr große Krümmungsradien auszeichnet, so daß das erfindungsgemäße Halbleiterbauelement große Durchbruchsspannungen besitzt.

4 Patentansprüche
2 Figuren

## Patentansprüche

1. Halbleiterbauelement, mit mindestens einem pn-Übergang, der in einem Halbleiterkörper des einen Leitungstyps ausgeführt ist, auf dem eine Isolierschicht aufgetragen ist, die den an die Oberfläche des Halbleiterkörpers tretenden pn-Übergang überdeckt, mit einem im Abstand vom pn-Übergang vorgesehenen Schutzring und mit einem die Isolierschicht überdeckenden Film, d a - d u r c h   g e k e n n z e i c h n e t ,   daß der Film (13) halbisolierend ist und mindestens zwei Bereiche mit einem genau festlegbaren Potential hat.

2. Halbleiterbauelement nach Anspruch 1, d a d u r c h   g e k e n n z e i c h n e t ,   daß der Film (13) aus amorphem Silicium besteht.

3. Halbleiterbauelement nach Anspruch 1 oder 2, d a - d u r c h   g e k e n n z e i c h n e t ,   daß der Film (13) vorzugsweise 500 Å dick ist.

4. Halbleiterbauelement nach einem der Ansprüche 1 bis 4, d a d u r c h   g e k e n n z e i c h n e t ,   daß die Isolierschicht (4) aus Siliciumdioxid beziehungsweise Siliciumdioxid und Siliciumnitrid besteht.

FIG 1

FIG 2